# EUROPEAN PATENT APPLICATION

(11) **EP 3 506 338 A1**
(43) Date of publication of application: **03.07.2019**
(21) Application number: 18209353.4
(22) Date of filing: 29.11.2018
(51) Int. Cl.: H01L 21/60, H05K 3/40, H01L 21/48, H01L 23/485, H01L 23/498

(54) **PREVENTION OF MISSING BUMP DUE TO GALVANIC CORROSION BY MEANS OF COPPER BUMP SIDEWALL PROTECTION**

(30) Priority: 30.12.2017 US 201715859481
(71) Applicant: INTEL Corporation, Santa Clara, CA 95054 (US)
(72) Inventor: PARK, Ji Yong, Chandler, AZ Arizona 85286 (US); LEE, Kyu Oh, Chandler, AZ Arizona 85286 (US); XU, Cheng, Chandler, AZ Arizona 85248 (US); KIM, Seo Young, Chandler, AZ Arizona 85248 (US)
(74) Representative: 2SPL Patentanwälte PartG mbB

(57) **Abstract**

Embodiments include semiconductor packages and a method of forming the semiconductor packages. A semiconductor package includes a resist layer disposed on a conductive layer. The semiconductor package also has a bump disposed on the conductive layer. The bump has a top surface and one or more sidewalls. The semiconductor package further includes a surface finish disposed on the top surface and the one or more sidewalls of the bump. The semiconductor package may have the surface finish surround the top surface and sidewalls of the bumps to protect the bumps from Galvanic corrosion. The surface finish may include a nickel-palladium-gold (NiPdAu) surface finish. The semiconductor package may also have a seed disposed on a top surface of the resist layer, and a dielectric disposed on the seed. The dielectric may surround the sidewalls of the bump. The semiconductor package may include the seed to be an electroless copper seed.

## Description

### FIELD

Embodiments relate to packaging semiconductor devices. More particularly, the embodiments relate to packaging semiconductor devices having a bump (*e.g.,* a copper (Cu) bump/pad) surrounded with a surface finish around each sidewall of the bump.

### BACKGROUND

Packaging of semiconductor devices, such as integrated circuits (ICs), present several problems. One of the main problems invovled with packaging ICs includes failure modes at the various interconnect levels (*e.g.,* at a first-level interconnect (FLI)). These failure modes are typically associated with missing bumps and over-etched bumps at an interconnect level due to Galvanic corrosion.

Glavnic corrosion is the electrochemical process in which a metal corrodes, especially as the metal electrically contacts another metal, in the presence of an electrolyte. This corrosion, for example, impacts the formation of ICs such as the fabrication of bumps to interconnect microelectronic devices. ICs are typically formed on a semiconductor wafer made of materials such as silicon. The semiconductor wafer is then processed to form various electronic devices. The wafers is usually diced into semiconductor chips (or dies), which may then be attached to a substrate. The substrate is typically designed to couple the die, directly or indirectly, to a printed circuit board (PCB), socket, or other connection. The substrate may also perform one or more other functions such as protecting, isolating, insulating, and/or thermally controlling the die.

The substrate (*e.g*., an interposer) has traditionally been formed from a core made up of a laminated multilayer structure. Typically, bumps (or microbumps) and other such interconnect structures are variously formed in or on the structure to facilitate electrical coupling of a die to one or more other devices, such as at the FLI. As successive generations of fabrication technologies continue to scale in size, metallurgical properties of various materials have an increasingly significant impact on the formation and operation of interconnect structures.

There is an increasing demand for incremental improvements in the fabrication of structures to interconnect microelectronic devices. These improvements are necessary in FLI structures as missing bumps due to Galvanic corrosion are prevalent contributors to FLI failure modes. A missing bump in Cu FLI generally occurs due to the potential difference between Cu and gold (Au) during the electroless Cu removal, as the Cu bump is connected to the Au-terminated die side capacitor (DSC) pad or the Au-terminated land side capacitor (LSC) pad (*e.g.,* the yield loss of the device may increase to roughly 100% based on the FLI design). Some packaging solutions to reduce this yield loss associated to Galvanic corrosion may include optimizing the electroless Cu removal condition or developing new chemical properties that are less invasive. These packaging solutions, however, require increased assembly costs, uncertainty, and time. As such, there is an increased demand to mitigate Galvanic corrosion in interconnecting structures in ICs without increasing assembly costs, uncertainty, and time.

### BRIEF DESCRIPTION OF THE DRAWINGS

Embodiments described herein illustrated by way of example and not limitation in the figures of the accompanying drawings, in which like references indicate similar features. Furthermore, some conventional details have been omitted so as not to obscure from the inventive concepts described herein.
Figures 1A - 1D are cross-sectional views of a process flow to form a semiconductor package having a bump surrounded with a surface finish above and around each sidewall of the bump, according to some embodiments.
Figure 2 is a plan view of a semiconductor package having a dielectric layer with a plurality of bumps surrounded by a plurality of gap openings formed between each bump and the dielectric layer, according to one embodiment.
Figure 3 is a cross-sectional view of a semiconductor package having a plurality of bumps surrounded with a surface finish above and around the side walls of the bumps, according to one embodiment.
Figure 4 is a process flow illustrating a method of a semiconductor package that includes a bump surrounded with a surface finish above and around each sidewall of the bump, according to one embodiment.
Figure 5 is a schematic block diagram illustrating a computer system that utilizes a semiconductor package having a bump surrounded with a surface finish above and around each sidewall of the bump, according to one embodiment.

### DETAILED DESCRIPTION

Described herein are systems that include semiconductor packages with sidewall protection on one or more bumps (or copper (Cu) bumps) and methods of forming such semiconductor packages. According to some embodiments, the semiconductor package described below and methods of forming such semiconductor package include a resist layer on a conductive layer, a bump disposed on the conductive layer, where the bump has a top surface and one or more sidewalls, and a surface finish on the top surface and the one or more sidewalls of the bump. For one embodiment, the surface finish may include a nickel-palladium-gold (NiPdAu) surface (or plated) finish that surrounds the top surface and sidewalls of the bump, which enables Galvanic corrosion protection throughout the entire surface of the bump rather than disposing the surface finish only the top surface of the bump.

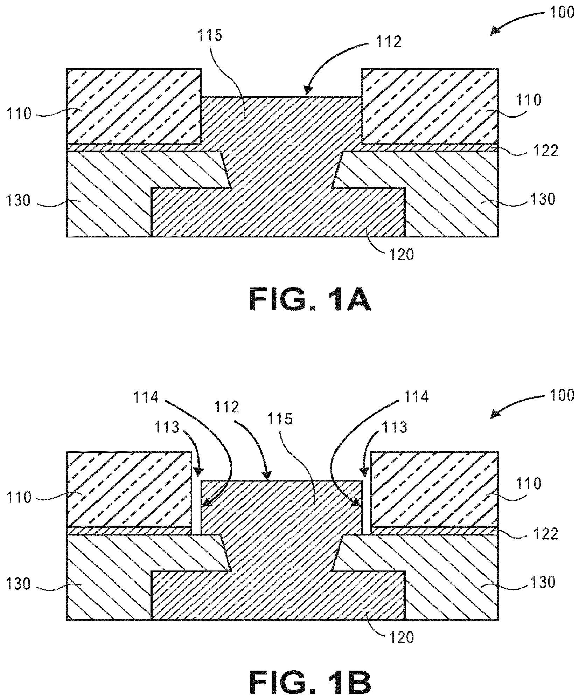

In some semiconductor package (*e.g*., package on package (PoP)) substrates, there are more than one interconnect areas, such as PoP interconnects and controlled collapse chip connection (C4) interconnects, present on the same substrate. A surface finish deposited (or disposed) only on the top surface of the interconnects (or bumps) does not reduce failures (*e.g.,* a missing bump) of the interconnects. To reduce the failures and improve the yield of the semiconductor packages, the embodiments described herein apply a surface finish (*e.g*., an electroless NiPdAu surface finish) to the one or more interconnect areas by disposing the surface finish on the top surface and sidewall(s) of each interconnect/bump. According to some embodiments, the surface finish can be used to provide good solder joint reliability (SJR) for the one or more interconnects and ultimately mitigate missing bumps due to Galvanic corrosion. A new substrate fabrication process (*e.g*., as shown in Figures 1A - ID) can be used to etch the sidewalls of a bump (*i.e.,* a gap is formed between the dielectric and the bump) and then dispose the surface finish above and around the top surface and sidewalls of the bump. Accordingly, these embodiments described herein enable a semiconductor package to have interconnect structures with no exposed Cu on both the top surface and the sidewalls of interconnect structures.

Embodiments of the semiconductor package enhance packaging solutions by protecting the interconnect structures with a NiPdAu surface finish (*i.e.,* having no exposed Cu on the sidewalls of the Cu bump). For example, the NiPdAu surface finish has proven to be an excellent surface finish for SJR under electrical and thermal aging. Embodiments of the semiconductor package can further decrease the yield loss of the package (or devices) associated with one or more missing bumps and/or over-etched bumps. In addition, the embodiments of the semiconductor package help to maximize the surface area of a substrate in order to free up space for the die side capacitors (DSCs) and land side capacitors (LSCs) connections on the package. Furthermore, the embodiments of the semiconductor package, as described herein, help to mitigate Galvanic corrosion at a first-level interconnect (FLI) to decrease the FLI failure modes associated with missing bumps and/or over-etched bumps.

Moreover, these embodiments described herein enhance the demand for improvements in the fabrication of structures to interconnect microelectronic devices using the NiPdAu surface finish. For example, the deposition of NiPdAu surface finish enables a decreased yield loss in Cu FLI structures as missing bumps due to Galvanic corrosion are mitigated. Accordingly, the embodiments described herein provide interconnect structures with a surface finish (*e.g.,* a NiPdAu surface finish) that prevents (or significantly hinders) Galvanic corrosion in interconnect structures on the semiconductor package - without increasing assembly costs, uncertainty, and time.

Note that, for some alternative embodiments, a variety of other surface finishes can be used such as, but not limited to, electrolytic NiPdAu, electrolytic PdAu, electrolytic NiPd, among others. Also note that while a NiPdAu process is illustrated herein a variety of other finishes suitable for one or more interconnect structures can be used depending on the application and/or desired packaging design.

Lastly, the embodiments described herein provide techniques and mechanisms for improved protection of interconnect structures (*e.g*., bumps/pads, microbumps, Cu bumps, etc.). A bump may include any type of bumps that include a Cu seed layer, and the bump may also include a combination of one or more metals (*e.g.,* Cu, Cu-NiPdAu, Cu-OSP, Cu-Sn, etc.). As used herein, a "bump" (also referred to herein as a "Cu bump," "bump," and/or a "microbump") is variously used to refer to at least one of a conductive contact (or pad) of a device and a solder joint (or a bump/pad) formed on such a conductive contact. In addition, a "bump" may refer to a solder joint formed by soldering with a microbump (where such a solder joint could also be referred to colloquially as a "microbump").

The technologies described herein may be implemented in one or more electronic devices. Non-limiting examples of electronic devices that may utilize the technologies described herein include any kind of mobile device and/or stationary device, such as cameras, cell phones, computer terminals, desktop computers, electronic readers, facsimile machines, kiosks, netbook computers, notebook computers, internet devices, payment terminals, personal digital assistants, media players and/or recorders, servers (e.g., blade server, rack mount server, combinations thereof, etc.), set-top boxes, smart phones, tablet personal computers, ultra-mobile personal computers, wired telephones, combinations thereof, and the like. Such devices may be portable or stationary. In some embodiments, the technologies described herein may be employed in a desktop computer, laptop computer, smart phone, tablet computer, netbook computer, notebook computer, personal digital assistant, server, combinations thereof, and the like. More generally, the technologies described herein may be employed in any of a variety of electronic devices including a substrate including interconnect structures to provide connectivity to integrated circuitry.

In the following description, various aspects of the illustrative implementations will be described using terms commonly employed by those skilled in the art to convey the substance of their work to others skilled in the art. However, it will be apparent to those skilled in the art that the present embodiments may be practiced with only some of the described aspects. For purposes of explanation, specific numbers, materials and configurations are set forth in order to provide a thorough understanding of the illustrative implementations. However, it will be apparent to one skilled in the art that the present embodiments may be practiced without the specific details. In other instances, well-known features are omitted or simplified in order not to obscure the illustrative implementations.

Various operations will be described as multiple discrete operations, in turn, in a manner that is most helpful in understanding the present embodiments, however, the order of description should not be construed to imply that these operations are necessarily order dependent. In particular, these operations need not be performed in the order of presentation.

Figures 1A - ID are cross-sectional views of a process flow to form a semiconductor package having a bump surrounded with a surface finish above and around each sidewall of the bump, according to some embodiments. These embodiments as shown with respect to Figures 1A - ID provide a fabricating process to develop sidewall protection for interconnect structures for any desired packaging needs, including, but not limited to, missing bump reduction, over-etched bump reduction, and decreased yield loss and FLI failure modes.

One such embodiment is illustrated and described based on Figures 1A - ID, which illustrates cross-sectional views of a package layer 100 (or substrate) used to form a Cu bump surrounded with a surface finish (*e.g*., NiPdAu). In the illustrated embodiments, the deposition of the surface finish on the bump is shown, however it is to be appreciated that additional features, such as additional components, bumps, layers, lines, vias, and/or pads, may be formed at the same time and with the same processing operations, according to the embodiments described herein.

Referring now to Figure 1A, the package layer 100 may include a resist layer 130 disposed on a conductive layer 120 (or an initial top metal layer (*e.g.,* Cu layer)), where the conductive layer 120 may have one or more pads, vias, and/or traces. For one embodiment, the package layer 100 of Figure 1A illustrates at least one interconnect layer of a semiconductor package (or substrate) that has the conductive layer 120 and the resist layer 130. According to one embodiment, this package layer 100 is shown with the conductive layer 120 having an existing pad and via, but additional pads, vias, and traces may be formed below and coupled to the initial conductive layer 120 (which may be omitted for simplicity).

For one embodiment, the resist layer 130 may be a solder resist layer, a solder mask, a solder stop mask, and/or any similar resist layer. The resist layer 130 may be a thin layer of polymer(s) that is usually applied to the Cu traces (*e.g.,* the conductive layer 120) of a package layer (*e.g.,* a printed circuit board (PCB) or substrate) for protection against oxidation and to prevent solder bridges from forming between closely spaced bumps/pads. According to one embodiment, the resist layer 130 may be an epoxy, a photoimageable solder mask, a photoimageable ink, and a dry film photoimageable solder mask.

As shown in Figure 1A, a seed layer 122 is disposed on the resist layer 130 and a dielectric layer 110 is then disposed on the seed layer 122. For one embodiment, a bump 115 (*e.g.,* a Cu bump) is disposed (or deposited) on the conductive layer 120 within an opening formed/patterned on the dielectric layer 110. According to some embodiments, the seed layer 122 is an electroless Cu seed layer that is deposited over a top surface of the resist layer 130. For example, electroless plating or physical vapor deposition (*i.e.,* sputtering) techniques may be used to deposit the seed layer 122. By way of illustration and not limitation, electroless plating of pure Cu may be used to form the seed layer 122 to have a desired thickness based on the packaging design/application (*e.g*., in a range of 0.1 µm to 2.0 µm, or any other desired thicknesses). In another embodiment, a combination of Cu and titanium (Ti) may be sputtered to form the seed layer 122. Note that the seed layer 122 may have any of various other material compositions and/or thicknesses, in alternative embodiments.

By way of example, the dielectric layer 110 may be a polymer material, such as, for example, a dry film resist (DFR), a polyimide, an epoxy, or a build-up film (BF). In one embodiment, the dielectric layer 110 may be one layer in a stack that includes a plurality of dielectric layers used to form a build-up structure. As such, the dielectric layer 110 may be formed over another dielectric layer. Additional embodiments may include forming the dielectric layer 110 as the first dielectric layer over a core material on which the stack is formed. For one embodiment, the dielectric layer 110 is patterned to provide the opening for the formation of the bump 115 on the conductive layer 120. Accordingly, the bump 115 has a top surface 112 that is exposed (and, thus, formed between the dielectric layer 110).

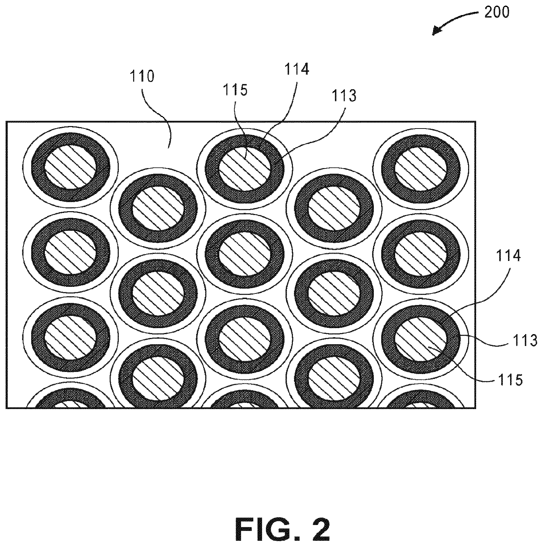

Referring now to Figure 1B, according to some embodiments, the bump 115 is etched between the dielectric layer 110 and the bump 115, providing one or more gap openings 113 between the dielectric 110 and the bump 115. For the one embodiment, the bump 115 may be etched (or removed) on both the top surface and side walls to expose one or more sidewalls 114 using a Cu seed etching process (*e.g.,* a controlled etching process) or the like. For some embodiments, the etching process provides the gap opening 113 which may extend vertically from the top surface 112 of the bump 115 to the top surface of the resist layer 130 (*i.e.,* the gap 113 extends through the seed layer 122 onto the top surface of the resist layer 130). Note that the bump 114 may have a single sidewall when the desired bump shape is circular, however the bump 114 may two or more sidewalls based on a different desired shape (*e.g.,* a rectangular pad). In addition, as shown in Figure 2 with a top view of a package layer (similar to the package layer 100 of Figure 1B), the package layer may have a plurality of bumps (*e.g*., the bump 115 of Figure 1B) surrounded with a dielectric layer (*e.g*., the dielectric layer 110 of Figure 1B), where each bump has a gap opening (*e.g.,* gap 113 of Figure 1B) between the dielectric layer and a sidewall (*e.g.,* the sidewall 114 of Figure 1B) of the bump.

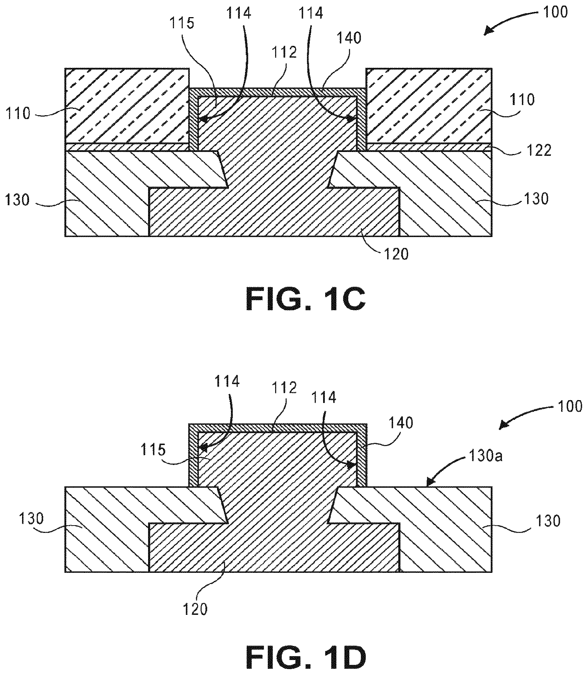

Referring now to Figure 1C, a surface finish 140 is deposited above and around the top surface 112 and sidewall(s) 114 of the bump 115. For one embodiment, the surface finish 140 may include a combination of Ni, Pd, and Au (*i.e.,* a NiPdAu surface finish). The surface finish 140 may be an electroless deposition of NiPdAu on the top surface 112 of the bump 115, and on the exposed gap opening(s) (*i.e*., the gap opening(s) 113 as shown in Figure 1B) between the dielectric 110 and the sidewalls 114 of the bump 115. Note that the surface finish 140 may be shown as having a rectangular shape surrounding the top surface 112 and sidewalls 114 of the bump 115, however the surface finish 140 may conform to any desired shape based on the gap openings and the shape of the bump (*e.g*., the surface finish may have a rounded shape, or a slanted (or tapered) shape).

Referring now to Figure ID, the package layer 100 has the dielectric layer 110 removed, and the exposed seed layer 122 is then removed. According to one embodiment, the seed layer 122 may be removed with a seed etching process which exposes the top surface 130a of the resist layer 130. For an alternative embodiment, the bump 115 with the surface finish 140 may be formed prior to the formation of a second dielectric layer (not shown). For one embodiment, the dielectric removal process may include a wet etch, a dry etch (*e.g.,* a plasma etch), a wet blast, or a laser ablation (*e.g*., by using excimer laser). According to one additional embodiment, the depth controlled dielectric removal process may be performed only proximate to the bump 115.

As such, after the removal process illustrated in Figure ID, the package layer 100 (or a semiconductor package) may include a resist layer 130 disposed on a conductive layer 120. The package layer 100 may also have a bump 115 disposed on the conductive layer 120, where the bump 115 has a top surface 112 and one or more sidewalls 114. The one or more sidewalls 114 may be exposed by forming a gap opening (*e.g.,* gap opening 113 as shown in Figure 1B) between a dielectric layer 110 and the bump 115. In addition, the package layer 100 has a surface finish 140 (*e.g.,* NiPdAu) disposed/deposited on the top surface 112 and the one or more sidewalls 114 of the bump 115.

Accordingly, these embodiments as illustrated in Figures 1A - ID enable both the top surface 112 and sidewall(s) 114 of the Cu bump 115 to be covered (or surrounded) with a NiPdAu surface finish 140. The NiPdAu surface finish 140 thus provides sidewall (and top) protection of the Cu bump 115, which helps the Cu bump 115 to not be exposed and etched during the electroless Cu removal (as shown in Figure ID). This sidewall protection of the surface finish 140, therefore, allows for a reduction in missing bumps and over-etched bumps associated with Galvanic corrosion. In addition, these embodiments as illustrated with the process flow of Figures 1A - ID enable a semiconductor package to have (i) a decreased yield loss due to missing bumps (and/or over-etched bumps) and (ii) additional space to route/design the DSC/LSC connections.

Note that package layer 100 of Figures 1A - 1D may include fewer or additional packaging components based on the desired packaging design.

Figure 2 is a plan view of a semiconductor package 200 (or substrate) having a dielectric layer 110 with a plurality of bumps 115 surrounded by gap openings 113, according to one embodiment. Note that the semiconductor package 200 of Figure 2 is similar to the package layer 100 of Figures 1A - 1D, however the semiconductor package 200 includes a plurality of bumps 115. As such, the process flow illustrated in Figures 1A - 1D may be used to form the semiconductor package 200.

For one embodiment, the gap openings 113 may be formed between each bump 115 and the dielectric layer 110, where the gap openings 113 may be formed with a Cu etching process (as shown in Figure 1B). According to one embodiment, the semiconductor package 200 may have the dielectric layer 110 formed with a plurality of bumps 115. The dielectric layer 110 may surround each bump 115 and have a gap opening 113 formed between the dielectric layer 100 and one or more sidewalls 114 of each bump 115.

Note that the semiconductor package 200 may include fewer or additional packaging components based on the desired packaging design.

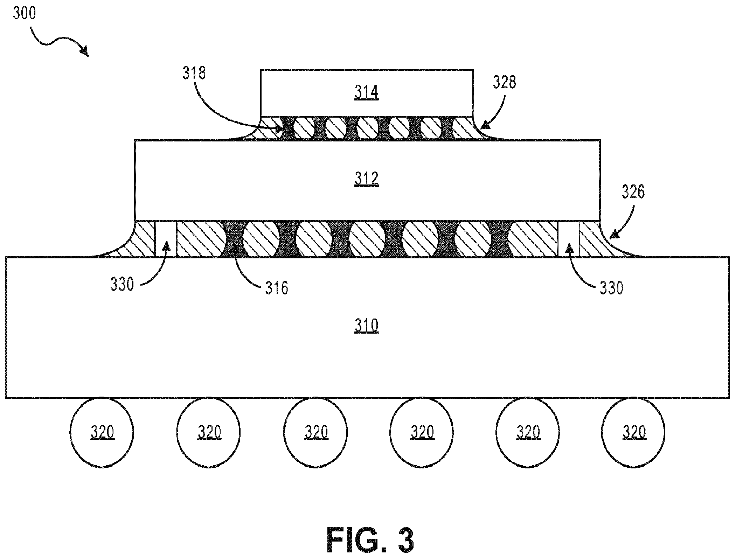

Figure 3 is a cross-sectional view of a semiconductor package 300 having a plurality of bumps surrounded with a surface finish above and around the side walls of the bumps, according to one embodiment. Specifically, Figure 3 illustrates the semiconductor package 300 including interconnect structures (*e.g*., the plurality of bumps disposed below a die 314 and an interposer 312), according to some embodiments. For one embodiment, the semiconductor package 300 may include a bump (or Cu bump/pad) that is surrounded with a surface finish (*e.g*., NiPdAu surface finish) on the top surface and sidewalls of the bump (as shown in Figures 1 - 2).

The semiconductor package 300 is merely one example of an embodiment wherein an integrated circuit die 314 is coupled to a substrate (*e.g*., an interposer) 312 via one or more bumps/joints formed from respective microbumps. For example, these bumps may be formed from the process flow shown in Figures 1A - ID and/or on the substrate 200 (*e.g*., bumps 115 of Figure 2). As described above, a solder joint formed by soldering of a microbump according to an embodiment may itself be referred to as a "bump" and/or a "microbump."

For some embodiments, the semiconductor package 300 may have a die 314 disposed on an interposer 312, where both the stacked die 314 and interposer 312 are disposed on a package substrate 310. According to some embodiments, the package substrate 310 may include, but is not limited to, a package, a substrate, a printed circuit board (PCB), and a motherboard. For one embodiment, the package substrate 310 is a PCB. For one embodiment, the PCB is made of an FR-4 glass epoxy base with thin copper foil laminated on both sides (not shown). For certain embodiments, a multilayer PCB can be used, with pre-preg and copper foil (not shown) used to make additional layers. For example, the multilayer PCB may include one or more dielectric layers, where each dielectric layer can be a photosensitive dielectric layer (not shown). For some embodiments, holes (not shown) may be drilled in the PCB 310. For one embodiment, the PCB 310 may also include conductive copper traces, metallic pads, and holes (not shown).

For one embodiment, the die 314 may include, but is not limited to, a semiconductor die, an electronic device (*e.g.,* a wireless device), an integrated circuit, a central processing unit (CPU), a microprocessor, a platform controller hub (PCH), a memory, and a field-programmable gate array (FPGA). The die 314 may be formed from a material such as silicon and have circuitry thereon that is to be coupled to the interposer 312. Although some embodiments are not limited in this regard, the package substrate 310 may in turn be coupled to another body, for example, a computer motherboard (not shown). One or more connections between the package substrate 310, the interposer 312, and the die 314 - *e.g*., including some or all of bumps 316, 318, and 320 - may have a surface finish that may include NiPdAu metallurgy. In some embodiments, these interconnect structures (or connections) may variously comprise an alloy of nickel, palladium, and tin (and, in some embodiments, copper). By way of illustration and not limitation, one or more of the bumps 316, 318, and/or 320 may include a NiPdAu surface finish that covers the top surfaces and the sidewalls of the bumps (*e.g*., as shown in Figure ID).

Connections between the package substrate 310 and another body may be made using any suitable structure, such as the illustrative bumps 320 shown. The package substrate 310 may include a variety of electronic structures formed thereon or therein. The interposer 312 may also include electronic structures formed thereon or therein, which may be used to couple the die 314 to the package substrate 310. For one embodiment, one or more different materials may be used for forming the package substrate and the interposer. In certain embodiments, the package substrate 310 is an organic substrate made up of one or more layers of polymer base material, with conducting regions for transmitting signals. In certain embodiments, the interposer 312 is made up of a ceramic base material including metal regions for transmitting signals. Although some embodiments are not limited in this regard, the semiconductor package 300 may include gap control structures 330 - *e.g.,* positioned between the package substrate 310 and the interposer 312. Such gap control structures 330 may mitigate a change in the height of the gap between the package substrate 310 and the interposer 312, which otherwise might occur during reflowing while die 314 is attached to interposer 312. Note that the semiconductor package 300 includes an underflow material 328 between the interposer 312 and the die 314, and an underflow material 326 between the package substrate 310 and the interposer 312. The underflow materials (or layers) 326 and 328 may be one or more polymers that are injected between the layers.

Note that the semiconductor package 300 may include fewer or additional packaging components based on the desired packaging design.

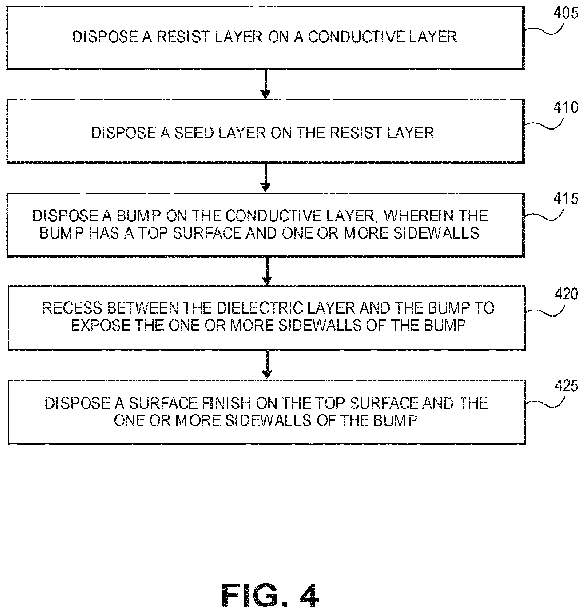

Figure 4 is a process flow illustrating a method of a semiconductor package that includes a bump surrounded with a surface finish above and around each sidewall of the bump, according to one embodiment. For one embodiment, the process flow 400 includes one or more steps used to form the semiconductor packages as described herein (*e.g.,* the semiconductor packages 100 of Figure 1 and 300 of Figure 3).

At block 405, the process flow 400 disposes a resist layer on a conductive layer (*e.g.,* as shown in Figure 1A). At block 410, the process flow 400 disposes a seed layer on the resist layer (*e.g.,* as shown in Figure 1A). In addition, the process flow may also include disposing a dielectric layer on the seed layer. At block 415, the process flow 400 disposes a bump on the conductive layer, where the bump has a top surface and one or more sidewalls (*e.g*., as shown in Figure 2). At block 420, the process flow 400 recesses (or etches) between the dielectric layer and the bump to expose the one or more sidewalls of the bump (*e.g*., the exposed sidewalls 113 as shown in Figure 1B and Figure 2). For example, the bump may be etched on both the sidewalls and the top surface.

At block 425, the process flow 400 disposes a surface finish (*e.g*., NiPdAu surface finish/layer) on the top surface and the one or more sidewalls of the bump (*e.g*., as shown in Figures 1C and ID). For example, the process flow may include disposing/depositing a NiPdAu surface finish (*e.g*., surface finish 140) on the top surface and the one or sidewalls of the bump (*e.g.,* the top surface 112 and sidewalls 113 of the bump 115). In addition, the process flow may remove/strip the dielectric layer and then the seed layer (*e.g*., using an electroless Cu removal process) to expose the top surface of the resist layer (*e.g.,* the top surface 130a of the resist 130 as shown in Figure ID).

For additional embodiments, the process flow may have the surface finish be an electroless surface finish. The process flow may also include that the electroless surface finish is a nickel-palladium-gold (NiPdAu) surface finish (note that the surface finish may include one or more different materials and/or processing techniques). Moreover, the process flow may dispose a seed on a top surface of the resist layer, and dispose a dielectric on the seed, where the dielectric surrounds the one or more sidewalls of the bump (as shown in Figure 1A). The process flow may include that the seed is an electroless copper seed. The process flow may further form a gap opening between the dielectric and the one or more sidewalls of the bump, where the one or more sidewalls of the bump are exposed by the gap opening (as shown in Figure 1B). The process flow may include that the bump is a copper bump. In addition, the process flow may have the dielectric to include a polymer material. In addition, the process flow may use the surface finish on (to cover/surround) a plurality of bumps that may be used to couple at least two or more of a die, an interposer, and a substrate.

Note that the semiconductor package formed by process flow 400 may include fewer or additional packaging components based on the desired packaging design (*e.g.,* as shown in Figures 1-3).

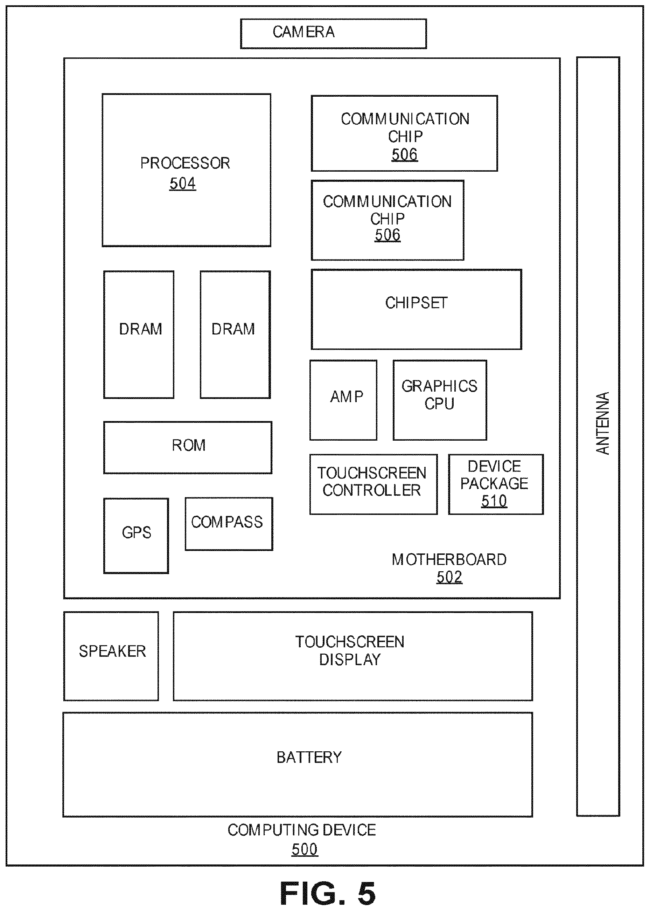

Figure 5 is a schematic block diagram illustrating a computer system that utilizes a semiconductor package having a bump surrounded with a surface finish above and around each sidewall of the bump, according to one embodiment. Figure5 illustrates an example of computing device 500. Computing device 500 houses motherboard 502. For one embodiment, motherboard 502 may be similar to the package substrate of Figure 3 (*e.g*., substrate 310 of Figure 3). Motherboard 502 may include a number of components, including but not limited to processor 504, semiconductor package 510, and at least one communication chip 506. Processor 504 is physically and electrically coupled to motherboard 502. For some embodiments, at least one communication chip 506 is also physically and electrically coupled to motherboard 502. For other embodiments, at least one communication chip 506 is part of processor 504.

Depending on its applications, computing device 500 may include other components that may or may not be physically and electrically coupled to motherboard 502. These other components include, but are not limited to, volatile memory (*e.g*., DRAM), non-volatile memory (*e.g.,* ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

At least one communication chip 506 enables wireless communications for the transfer of data to and from computing device 500. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. At least one communication chip 506 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. Computing device 500 may include a plurality of communication chips 406. For instance, a first communication chip 406 may be dedicated to shorter range wireless communications such as Wi-Fi and Bluetooth and a second communication chip 506 may be dedicated to longer range wireless communications such as GPS, EDGE, GPRS, CDMA, WiMAX, LTE, Ev-DO, and others.

Processor 504 of computing device 500 includes an integrated circuit die packaged within processor 504. Device package 510 may be, but is not limited to, a packaging substrate and/or a printed circuit board. Device package 510 may be a semiconductor package with a bump surrounded with a surface finish above and around each sidewall of the bump (as illustrated in Figures 1-3) - or any other components from the figures described herein - of the computing device 500. Further, as described herein, the device package 510 may help lower the yield loss of the computing device 500 by mitigiating Galvanic corrosion in interconnecting structures (*e.g.,* FLI) with the surface finish (*e.g.,* NiPdAu) surrounding/covering the Cu interconnect structures - without increasing assembly costs, uncertainty, and time.

Note that device package 510 may be a single component/device, a subset of components, and/or an entire system, as the materials, features, and components may be limited to device package 410 and/or any other component of the computing device 500 that may need the surface finish layer around the Cu interconnect structures (*e.g*., Cu bump, Cu pad, microbump, bump/pad, etc.).

For certain embodiments, the integrated circuit die may be packaged with one or more devices on a package substrate that includes a thermally stable RFIC and antenna for use with wireless communications and the device package, as described herein, to reduce the z-height of the computing device. The term "processor" may refer to any device or portion of a device that processes electronic data from registers and/or memory to transform that electronic data into other electronic data that may be stored in registers and/or memory.

At least one communication chip 506 also includes an integrated circuit die packaged within the communication chip 506. For some embodiments, the integrated circuit die of the communication chip may be packaged with one or more devices on a package substrate that includes one or more device packages, as described herein.

In the foregoing specification, embodiments have been described with reference to specific exemplary embodiments thereof. It should be borne in mind, however, that all of these and similar terms are to be associated with the appropriate physical quantities and are merely convenient labels applied to these quantities. It will be evident that various modifications may be made thereto without departing from the broader spirit and scope. The specification and drawings are, accordingly, to be regarded in an illustrative sense rather than a restrictive sense.

The following examples pertain to further embodiments. The various features of the different embodiments may be variously combined with some features included and others excluded to suit a variety of different applications.

The following examples pertain to further embodiments:
Example 1 is a semiconductor package, comprising a resist layer on a conductive layer and a bump on the conductive layer. The bump has a top surface and one or more sidewalls; and a surface finish on the top surface and the one or more sidewalls of the bump.
In Example 2, the subject matter of example 1 can optionally include the surface finish that surrounds the top surface and the one or more sidewalls of the bump to protect the bump from corrosion.
In Example 3, the subject matter of any of examples 1-2 can optionally include the surface finish as a nickel-palladium-gold (NiPdAu) surface finish.
In Example 4, the subject matter of any of examples 1-3 can optionally include further comprising a seed on a top surface of the resist layer; and a dielectric on the seed. The dielectric surrounds the one or more sidewalls of the bump.
In Example 5, the subject matter of any of examples 1-4 can optionally include the seed as an electroless copper seed.
In Example 6, the subject matter of any of examples 1-5 can optionally include further comprising a gap opening formed between the dielectric and the one or more sidewalls of the bump. The one or more sidewalls of the bump are exposed by the gap opening.
In Example 7, the subject matter of any of examples 1-6 can optionally include the bump as a copper bump.
In Example 8, the subject matter of any of examples 1-7 can optionally include the dielectric which includes a polymer material.
Example 9 is a method of forming a semiconductor package, comprising of disposing a resist layer on a conductive layer and disposing a bump on the conductive layer. The bump has a top surface and one or more sidewalls; and disposing a surface finish on the top surface and the one or more sidewalls of the bump.
In Example 10, the subject matter of example 9 can optionally include the surface finish surrounding the top surface and the one or more sidewalls of the bump to protect the bump from corrosion.
In Example 11, the subject matter of any of examples 9-10 can optionally include the surface finish as a nickel-palladium-gold (NiPdAu) surface finish.
In Example 12, the subject matter of any of examples 9-11 can optionally include further comprising disposing a seed on a top surface of the resist layer; and disposing a dielectric on the seed. The dielectric surrounds the one or more sidewalls of the bump.
In Example 13, the subject matter of any of examples 9-12 can optionally include the seed as an electroless copper seed.
In Example 14, the subject matter of any of examples 9-13 can optionally include further comprising forming a gap opening between the dielectric and the one or more sidewalls of the bump. The one or more sidewalls of the bump are exposed by the gap opening.
In Example 15, the subject matter of any of examples 9-14 can optionally include the bump as a copper bump.
In Example 16, the subject matter of any of examples 9-15 can optionally include the dielectric which includes a polymer material.
Example 17 is a semiconductor package, comprising an interposer on a substrate; a die on the interposer; and a surface finish on a plurality of bumps. The plurality of bumps electrically couple the die to the interposer, and the interposer to the substrate.
In Example 18, the subject matter of example 17 can optionally include the surface finish surrounding the top surface and the one or more sidewalls of the bumps to protect the bumps from corrosion. Each bump has at least a top surface and one or more sidewalls. The surface finish is disposed on at least one of the top surface and the one or more sidewalls of each bump.
In Example 19, the subject matter of any of examples 17-18 can optionally include the surface finish as a nickel-palladium-gold (NiPdAu) surface finish.
In Example 20, the subject matter of any of examples 17-19 can optionally include the plurality of bumps which include a metallic material. The metallic material includes copper.
In Example 21, the subject matter of any of examples 17-20 can optionally include further comprising one or more underfill layers surrounding the plurality of bump.
In Example 22, the subject matter of any of examples 17-21 can optionally include the substrate which includes a package and a printed circuit board.
In Example 23, the subject matter of any of examples 17-22 can optionally include the die which includes an integrated circuit, a central processing unit, a microprocessor, a platform controller hub, a memory, and a field-programmable gate array.
In Example 24, the subject matter of any of examples 17-23 can optionally include further comprising a plurality of bumps electrically coupling the substrate to a second substrate.
In Example 25, the subject matter of any of examples 17-24 can optionally include the second substrate which includes a motherboard.

In the foregoing specification, methods and apparatuses have been described with reference to specific exemplary embodiments thereof. It will be evident that various modifications may be made thereto without departing from the broader spirit and scope. The specification and drawings are, accordingly, to be regarded in an illustrative sense rather than a restrictive sense.

## Claims

1. A semiconductor package, comprising:
a resist layer on a conductive layer;
a bump on the conductive layer, wherein the bump has a top surface and one or more sidewalls; and
a surface finish on the top surface and the one or more sidewalls of the bump.

2. The semiconductor package of claim 1, wherein the surface finish surrounds the top surface and the one or more sidewalls of the bump to protect the bump from corrosion.

3. The semiconductor package of claims 1-2, wherein the surface finish is a nickel-palladium-gold (NiPdAu) surface finish.

4. The semiconductor package of claims 1-3, further comprising:
a seed on a top surface of the resist layer; and
a dielectric on the seed, wherein the dielectric surrounds the one or more sidewalls of the bump.

5. The semiconductor package of claims 1-4, wherein the seed is an electroless copper seed.

6. The semiconductor package of claims 1-5, further comprising a gap opening formed between the dielectric and the one or more sidewalls of the bump, wherein the one or more sidewalls of the bump are exposed by the gap opening.

7. The semiconductor package of claims 1-6, wherein the bump is a copper bump.

8. The semiconductor package of claims 1-7, wherein the dielectric includes a polymer material.

9. A method of forming a semiconductor package, comprising:
disposing a resist layer on a conductive layer;
disposing a bump on the conductive layer, wherein the bump has a top surface and one or more sidewalls; and
disposing a surface finish on the top surface and the one or more sidewalls of the bump.

10. The method of claim 9, wherein the surface finish surrounds the top surface and the one or more sidewalls of the bump to protect the bump from corrosion.

11. The method of claims 9-10, wherein the surface finish is a nickel-palladium-gold (NiPdAu) surface finish.

12. The method of claim 9-11, further comprising:
disposing a seed on a top surface of the resist layer; and
disposing a dielectric on the seed, wherein the dielectric surrounds the one or more sidewalls of the bump.

13. The method of claims 9-12, wherein the seed is an electroless copper seed.

14. The method of claims 9-13, further comprising forming a gap opening between the dielectric and the one or more sidewalls of the bump, wherein the one or more sidewalls of the bump are exposed by the gap opening.

15. The method of claims 9-14, wherein the bump is a copper bump.
